Europäisches Patentamt

European Patent Office

Office européen des brevets

(19)

(11) Publication number: **0 081 062**
**A2**

(12) **EUROPEAN PATENT APPLICATION**

(21) Application number: **82109339.0**

(22) Date of filing: **08.10.82**

(51) Int. Cl.³: **H 03 G 3/00**

(30) Priority: **03.12.81 IT 4573581**

(43) Date of publication of application:
**15.06.83 Bulletin 83/24**

(84) Designated Contracting States:
**AT BE CH DE FR GB IT LI NL SE**

(71) Applicant: **ZANUSSI ELETTRONICA S.p.A.**
**Viale Treviso 15**
**I-33170 Pordenone(IT)**

(72) Inventor: **Masili, Dino**
**Via Manin 7**
**I-33080 Prata di Pordenone(IT)**

(72) Inventor: **Muzzolini, Dario**
**Via Urana 23**
**I-33010 Magnano in Riviera (Udine)(IT)**

(74) Representative: **Patentanwälte Grünecker, Dr.**
**Kinkeldey, Dr. Stockmair, Dr. Schumann, Jakob, Dr.**
**Bezold, Meister, Hilgers, Dr. Meyer-Plath**
**Maximilianstrasse 58**
**D-8000 München 22(DE)**

(54) Apparatus for reproducing audio signals with automatic control of the maximum output volume.

(57) An audio signal reproducing apparatus comprises a final stage (6,7) controlled by the output (5) of a volume control device (2) having a first and a second input controlled respectively by the audio signals and a control signal.

The control device transfers the audio signals to its output (5) at a volume which is proportional to the magnitude of the control signal. The output of said control device is compared to a reference voltage in a comparator (11) the output of which controls the second input of the volume control device.

Apparatus for Reproducing Audio Signals
with Automatic Control of the Maximum
Output Volume

D e s c r i p t i o n

The present invention relates to apparatus for reproducing audio signals which may be received from a radio or television transmitter or may be reproduced from an audio signal recording carrier.

It is generally known that the maximum volume of the audio signals at the output of soch reproducing apparatus may easily vary in response to the different modulation levels of the various tunable transmitter stations as well as in response to variations of the signal level occurring in the vicinity of a transmitting station.

These volume variations can be a considerable nuisance and are thus obviously undesirable.

According to the invention, there is provided an apparatus for reproducing audio signals, comprising a final stage controlled by the output of a volume control device having a first and a second input controlled respectively by the audio signals and a control signal, said control device being adapted to transfer to said output said audio signals with a volume proportional to the magnitude of said control signal. According to the invention, apparatus of the above defined type is substantially characterized in that said audio signals also control a first input of a comparator, the output of which controls the second input of said control device, a second input of said comparator being connected to a reference voltage source.

The reproducing apparatus according to the invention thus permits to maintain the volume, particularly the maximum volume, of the output audio signals, constant in an automatic manner, irrespective of variations of the modulation level of the input signals.

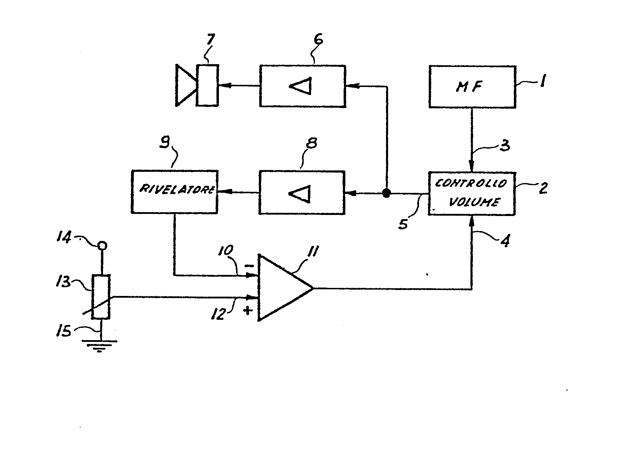

Further characteristics and advantages of the invention will become evident from the following description of an exemplary embodiment with reference to the accompanying drawing, the only figure of which shows a block circuit diagram of apparatus for reproducing audio signals in a preferred embodiment of the invention.

The apparatus for reproducing audio signals as shown generally comprises a medium frequency stage 1 at the output of which there appears a suitably processed audio signal as received at the (not shown) input of the apparatus as a whole.

The output of stage 1 controls a first input 3 of a device 2 for the DC control of volume. Stages 1 and 2 are of a known type and may be included in an integrated circuit such as for instance IC type TBA 120 made by Siemens. Control device 2 has a second input 4 supplied with a DC control signal, and is adapted to transfer to its output 5 the audio signal received from the medium frequency stage 1 with a volume which is proportional to the magnitude of said control signal. The output 5 of control device 2 controls the final stage of the apparatus comprising an output amplifyer 6 and at least one loudspeaker 7.

According to the invention, output 5 of control device 2 additionally controls, via an amplifyer stage 8, a peak indicator stage 9.

In a known manner, peak indicator 9 produces at its output a DC voltage proportional to the peak of the audio signal received from control device 2 and amplified by amplifyer stage 8.

The output of peak indicator 9 controls a first input 10 of a comparator stage consisting for instance of a limited gain op rational amplifyer 11.

The output of peak indicator 9 is thus connected to the inverting input of the operational amplifyer.

A second input 12 of comparator 11 is controlled by a preferably variable DC reference voltage. This reference voltage may for instance be derived from the sliding contact of a potentiometer 13 connected to the terminals 14 and 15 of a DC voltage source.

Comparator 11 at its output produces a DC error signal the magnitude of which is variable in response to a possible difference between the tensions applied to inputs 10 and 12.

The said error signal constitutes the above mentioned control signal applied to input 4 of control device 2 in the manner described.

In other words, the volume of the audio signal controlling the final stage 6, 7 is compared in comparator 11 with the reference voltage derived from the sliding contact of potentiometer 13.

This tension may be adjusted by the user and represents the desired maximum volume of the audio signal to be reproduced by loudspeaker 7.

As described above, the control signal generated by comparator 11 automatically controls the maximum volume of the output audio signal through control device 2 at a level corresponding to the above noted reference voltage, irrespective of variations of the maximum volume of the audio signals controlling medium frequency stage 1.

The described audio signal reproducing apparatus may of course be modified in various manners within the scope of the invention as defined by the appended claims.

Thus the input of peak indicator 9 may for instance be controlled by the output of amplifyer 6 instead of by the output 5 of control device 2. In this case the operation of the reproducing apparatus as a whole remains substantially unchanged.

GRUNECKER, KINKELDEY, STOCKMAIR & PARTNER

PATENTANWALTE
EUROPEAN PATENT ATTORNEYS

A GRUNECKER DR ING
DR H KINKELDEY DR ING
DR W STOCKMAIR DR ING AE E CALTECH
DR K SCHUMANN DR RER NAT
P H JAKOB DIPL ING
DR G BEZOLD DR RER NAT
W MEISTER DIPL ING
H HILGERS DIPL ING
DR H MEYER-PLATH DIPL ING

8000 MUNCHEN 22
MAXIMILIANSTRASSE 43

**0081062**

EP 763

Apparatus for Reproducing Audio Signals
with Automatic Control of the Maximum
Output Volume

P a t e n t   C l a i m s

1. Apparatus for reproducing audio signals, comprising a final stage controlled by the output of a volume control device having a first and a second input controlled respectively by the audio signals and a control signal, said control means being adapted to transfer to said output said audio signals with a volume proportional to the magnitude of said control signal, characterized in that said audio signals also control a first input (10) of a comparator (11), the output of which controls the second input (4) of said control device, a second input (12) of said comparator being connected to a reference voltage source (14, 15).

2.    Apparatus according to claim 1, <u>characterized in that</u> said audio signals control said first input (10) of said comparator (11) via a peak indicator (9).

3.    Apparatus according to claim 1, <u>characterized in that</u> said reference voltage source comprises means (13) for adjusting said reference voltage.